# EUROPÄISCHE PATENTSCHRIFT

(11) **EP 1 009 079 B1**
(45) Veröffentlichungstag und Bekanntmachung des Hinweises auf die Patenterteilung: **01.08.2007**
(21) Anmeldenummer: 99116339.5
(22) Anmeldetag: 19.08.1999
(51) Int. Cl.: H01S 5/024

(54) **Vorrichtung zur Begrenzung der Temperatur einer Lichtwellen emittierenden Laser-Diode**
Device for limiting the temperature of a light emitting laser device
Dispositif pour limiter la température d'un laser à diode pendant l'émission de lumière

(30) Priorität: 13.11.1998 CH 228398
(43) Veröffentlichungstag der Anmeldung: 14.06.2000
(73) Patentinhaber: Oerlikon Space AG, 8052 Zürich (CH)
(72) Erfinder: Kilburn, Ian James, 8180 Bülach (CH); Sanvido, Saverio, 8152 Glattbrugg (CH)
(74) Vertreter: OK pat AG

(56) Entgegenhaltungen:
- US-A- 5 371 753
- VANEVENHOVEN D E AND ANTONIAK D: "variable heat pipe technoligy for precise temperature control for the NASA/DDTL transmitter" PROCEEDINGS OF THE SPIE, THE INTERNATIONAL SOCIETY FOR OPTICAL ENGINEERING, OPTOMECHANICAL DESIGN OF LASER TRANSMITTERS AND RECIEVERS, LOS ANGELES CA, USA 16-17 JANUARI 1989, Bd. 1044, Seiten 135-144, XP002099473
- PATENT ABSTRACTS OF JAPAN vol. 097, no. 011, 28. November 1997 (1997-11-28) -& JP 09 199882 A (TOPCON CORP), 31. Juli 1997 (1997-07-31)
- PATENT ABSTRACTS OF JAPAN vol. 013, no. 023 (E-705), 19. Januar 1989 (1989-01-19) & JP 63 226952 A (HITACHI LTD;OTHERS: 01), 21. September 1988 (1988-09-21)

## Beschreibung

Die Erfindung betrifft eine Vorrichtung zur Begrenzung der Temperatur einer Lichtwellen emittierenden Laser-Diode nach dem Oberbegriff des Patentanspruchs **1**.

Die Übermittlung von Daten zwischen Satelliten im Weltraum erfolgt im allgemeinen optisch bzw. über Lichtwellen, wobei zur Erzeugung der Lichtwellen vorzugsweise Laser-Dioden benutzt werden. Es ist eine generelle Eigenschaft von Laser-Dioden, dass die Frequenzen der von ihnen emittierten Lichtwellen von der jeweiligen Arbeits-Temperatur der Laser-Dioden abhängig sind. Um eine einwandfreie Datenübertragung zu gewährleisten, müssen die jeweilige Frequenz der emittierten Lichtwellen und damit auch die Temperatur der Laser-Dioden möglichst invariant sein. Die Laser-Diode steht mittelbar, das heisst über mehrere konstruktive Elemente, mit einer Wärme-Senke in Verbindung, welche beispielsweise als Radiator ausgebildet sein oder aus einem Bestandteil der Struktur des Satelliten bestehen kann. Die Wärme-Senke und die Temperatur der Laser-Diode weisen Temperaturen auf, die sich in Abhängigkeit von äusseren Umständen laufend verändern können, einerseits in Abhängigkeit von der Lage der Satelliten sowohl bezüglich der Sonne wie der Erde wie auch bezüglich ihrer Stellung, und anderseits infolge Alters des Satelliten, da verschiedene Elektronikkomponenten mit zunehmenden Alter weniger effizient arbeiten und dadurch mehr Verlustenergie in Form von Wärme entsteht, sowie infolge der mit zunehmenden Alter sich vermehrenden Verschmutzung mit Staub, durch welchen die Satelliten eine dunklere Farbe annehmen, was zu einer vermehrten Absorption von UV-Sonnenstrahlung und damit zu einer Temperaturerhöhung führt.

In vielen Fällen wird eine konstante Arbeitstemperatur der Laser-Diode angestrebt. In gewissen Fällen kann es aber - insbesondere in Abhängigkeit von der Distanz der Gegenstation - auch erwünscht sein, dass die Temperatur der Laser-Diode andere Werte annimmt als die erstgenannte Arbeitstemperatur.

Da herkömmlicherweise die Wärmeleit-Kapazitäten der zwischen der Laser-Diode und der Wärme-Senke angeordneten konstruktiven Elemente als weitgehend konstant betrachtet werden, sind gewisse Massnahmen zu treffen, um zu verhindern, dass sich die Temperatur der Laser-Diode und damit die Frequenz der emittierten Lichtwellen unter den wechselnden Temperatureinflüssen auf die Laser-Diode verändern.

Bei einer ersten vorbekannten Massnahme wird wie folgt verfahren: die verschiedenen Bauteile sind so ausgebildet, dass bei extremalen Betriebsbedingungen, das heisst wenn die Wärme-Senke ihre Maximaltemperatur aufweist und die Wärme-Dissipation der Laser-Diode ebenfalls maximal ist, die Laser-Diode auf ihrer Arbeitstemperatur oder nur unwesentlich unter der Arbeitstemperatur liegt. Diese Bedingungen legen die als konstant betrachtete Menge der zwischen der Laser-Diode und der Wärme-Senke transferierten Wärme fest. Unter allen anderen Betriebsbedingungen muss dann die Laser-Diode mittels einer Heizvorrichtung beheizt werden, damit ihre Temperatur den erforderlichen Wert hat, da infolge des konstanten Wärme-Transfers eine höhere Wärmemenge als erforderlich von der Laser-Diode zur Wärme-Senke transferiert wird bzw. ein Wärme-Transfer stattfindet, der grösser ist als es eigentlich tatsächlich notwendig wäre. Nachteilig bei diesem Verfahren ist es, dass von der in einem Satelliten nur in begrenzter Menge zur Verfügung stehenden Energie ein Teil zur Beheizung der Laser-Diode verwendet werden muss und somit nicht für den eigentlichen Betrieb der Laser-Diode, also für die Emission von Lichtwellen, zur Verfügung steht.

Eine andere vorbekannte Massnahme zur Konstanthaltung der Temperatur der Laser-Diode besteht darin, eine thermo-elektrische Kühlvorrichtung für die Laser-Diode vorzusehen, um die Temperatur der Laser-Diode zu begrenzen. Der niedrige Wirkungsgrad des dabei stattfindenden Wärmepump-Vorganges sowie die zweifelhafte Zuverlässigkeit einer solchen Anordnung machen deren Einsatz in der Weltraumtechnik aber nicht attraktiv.

Aus der Publikation mit Titel "Variable conductance heat pipe technology for precise temperature control of the NASA/DDLT transmiter" von D.E. Vanevenhoven et al., SPIE Vol. 1044 Optomechanical Design of Laser Transmitters and Receivers (1989), pp. 135 - 144, ist eine Lösung bekannt, die eine Wärme-Transfer-Anordnung umfasst, durch welche Wärme von einer Laser-Diode zu einer Warme-Senke transferiert wird. Dabei hat die Wärme-Trensfer-Anordnung eine variable Wärme-Transfer-Kapazität hat, deren Wärme-Transfer-Kapazität direkt mit der Temperatur der laser-Diode korreliert ist. Diese Korrelation wird erreicht durch eine sogenannte Feedback Control.

Ein anderes Prinzip Ist der US-Potentschrift US 5,371,753 zu entnehmen, In der ein System beschrieben wird, das mittels Memory-Shape legierung eine thermische Brücke zwischen einem Laser und einer Wärmesenke herstellt.

Die Aufgabe der Erfindung wird somit darin gesehen, eine Vorrichtung der eingangs genannten Art zu schaffen, mit welcher unter Vermeidung der oben beschriebenen Nachteile die Temperatur der Laser-Diode auf einem vorbestimmten Wert bzw. innerhalb eines sehr beschränkten Bereiches gehalten werden kann.

Diese Aufgabe wird erfindungsgemäss durch die Merkmale des unabhängigen Patentanspruchs **1** gelöst. Vorteilhafte Weiterbildungen der erfindungsgemässen Vorrichtung sind durch die abhängigen Patentansprüche **2** bis **4** definiert.

Unter den Begriff des Wärme-Transfers sollen im Rahmen der vorliegenden Erfindung sowohl eigentliche Wärmeleitung, Konvektion und Wärmeübergang fallen, kurz alle Vorgänge, durch welche Wärme von der Laser-Diode via die Wärme-Transfer-Anordnung an die Wärme-Senke übergeht.

Es sei ferner angemerkt, dass der Wärme-Transfer zwischen der Laser-Diode und der Wärme-Senke in jedem Falle Wärmeübergänge zwischen den verschiedenen jeweils aneinander angrenzenden, zwischen der Laser-Diode und der Wärme-Senke angeordneten konstruktiven Elementen, ferner eigentliche Wärmeleitung und gegebenenfalls Konvektion innerhalb dieser Teile sowie Strahlung umfasst. Ausserdem wird Wärme von der Laser-Diode nicht nur an die Wärme-Transfer-Anordnung sondern auch an andere Elemente abgegeben. Die jeweils dabei gewissermassen unabsichtlich transferierten Wärmemengen sind aber verhältnismässig klein im Vergleich mit der absichtlich transferierten Wärmemenge.

Statt also wie in herkömmlicher Weise die Temperatur der Laser-Diode mittels zusätzlichem Energieaufwand, das heisst mittels Beheizung oder Kühlung, auf der erforderlichen Höhe bzw. konstant zu halten, wird erfindungsgemäss der sich ohnehin einstellende Wärme-Transfer von der Laser-Diode zur Wärme-Senke passiv so gesteuert, dass die Temperatur der Laser-Diode konstant bleibt. Dies geschieht dadurch, dass zwischen der Laser-Diode und der Wärme-Senke eine Wärme-Transfer-Anordnung gemäss der Kennzeichnenden Merkmale des Anspruchs 1 angeordnet sind.

Bei einer nicht beanspruchtur Ausführungsform weist die Wärme-Transfer-Anordnung ein Element mit variabler Wärmeleitfähigkeit auf. Obwohl solche Elemente an sich bekannt sind, und zwar unter den Bezeichnungen VCHP (Variable Conductance Heat Pipe), werden ihr Aufbau und ihre Wirkungsweise im folgenden kurz beschrieben. Jedes Element besteht im wesentlichen aus einem Hohlkörper, beispielsweise einem allseits geschlossenen Rohr, dessen Äusseres an seinem einen Ende mit einer Wärme-Quelle, im vorliegenden Falle also mit der Laser-Diode bzw. der Basis der Laser-Diode, und an seinem anderen Ende mit der Wärme-Senke verbunden ist. Der Hohlkörper enthält ein Arbeits-Fluid, der im Temperaturbereich, in welchem das Element eingesetzt wird, in einer Mischung von gasförmiger und flüssiger Phase vorkommt. Im Bereich der Laser-Diode nimmt das Arbeits-Fluid Wärme auf und verdampft, im Bereich der Wärme-Senke gibt das Arbeits-Fluid Wärme ab und kondensiert. Das Arbeits-Fluid strömt also als Gas vom Bereich der Laser-Diode zum Bereich der Wärme-Senke und als Flüssigkeit vom Bereich der Wärme-Senke zum Bereich der Laser-Diode. Der Wärme-Transfer im Rohr erfolgt im wesentlichen konvektiv, und nur ein geringer Teil der Wärme wird durch eigentliche Wärmeleitung, nämlich in den Rohrwandungen selbst, transferiert.

Innerhalb des Rohres entsteht eine verhältnismässig komplexe Strömung, und um die Wirkung des Rohres bezüglich des Wärme-Transfers zu verbessern, wird das Rohr vorzugsweise im Bereich seiner Wandung mit einem Einsatz in Form eines gitter- bzw. wabenähnlichen Gebildes versehen, so dass das Arbeits-Fluid infolge von Kapillarwirkung in flüssiger Form im Bereich der Rohrwandung strömt, während das Arbeits-Fluid in gasförmiger Form im zentralen Bereich des Rohres in entgegengesetzter Richtung strömt.

Die Wärme-Transfer-Kapazität solcher Rohre lässt sich beeinflussen, indem man ihr aktives Volumen bzw. dem Arbeits-Fluid zur Verfügung stehendes Volumen verändert. Zu diesem Zwecke wird dasjenige Ende des Rohres, welches im Bereich der Wärme-Senke angeordnet ist, als ein Inertgas enthaltendes Gas-Reservoir ausgebildet. Wird dem Rohr von der Diode weniger Wärme zugeführt, so dehnt sich das Inertgas aus, wodurch sich der Bereich, in welchem das Arbeits-Fluid kondensiert, verkleinert, worauf weniger Wärme an die Wärme-Senke abgegeben wird.

Die Steuerung des Wärme-Transfers mit Hilfe des Inertgases lässt sich weiterhin verbessern, wenn eine Heizvorrichtung für das Gas-Reservoir mit dem Inertgas vorgesehen wird. Durch eine Beheizung kann das Volumen des Inertgases vergrössert und damit der Wärmetransfer reduziert werden. Die für diese Beheizung erforderliche Energie ist bedeutend geringer als die Energie, die zur Heizung der Laser-Diode verwendet werden müsste, um letztlich denselben Effekt zu erreichen. Es ist offensichtlich, dass das beheizbare Gas-Reservoir in gewissem Masse gegen die Wärme-Senke isoliert sein sollte.

Da die Temperatur und damit die Länge solcher Rohre veränderlich ist, empfiehlt es sich, Rohre mit Rohrbogen und/oder Balgbereichen zu verwenden, um Materialspannungen, sei es innerhalb der Rohrwandungen, sei es im Bereich ihrer Befestigungen, zu vermeiden. Ausserdem muss die Befestigung der Endbereiche des Rohres so gestaltet sein, dass eventuelle Wärme-Dilatationen keine Lockerung zur Folge haben bzw. kompensiert werden können.

Geeignete Anordnungen von Rohrbogen erlauben eine platzsparende Anordnung weiterer Bauteile, beispielsweise der Elektronik.

In Fällen, in denen eine verhältnismässig grosse Wärmemenge zu transferieren ist, ist es empfehlenswert, anstelle eines Rohres mit grossem Durchmesser mehrere Rohre mit kleinen Durchmessern vorzusehen. Dadurch erhält man eine regelmässigere Temperaturverteilung an den Stellen des Wärmeüberganges zwischen Laser-Diode und Wärme-Transfer-Anordnung sowie zwischen Wärme-Transfer-Anordnung und Wärme-Senke. Ein weiterer Vorteil einer Anordnung mit mehrere Rohren liegt darin, dass der Ausfall eines einzelnen Rohres nicht allzusehr ins Gewicht fällt.

In gewissen Fällen, nämlich bei einer grossen Temperaturdifferenz zwischen Laser-Diode und Wärme-Senke sowie einer geringen zu transferierenden Wärmemenge, kann der Wärme-Transfer durch die in der Rohrwandung stattfindende Wärmeleitung geschehen. Zu diesem Zwecke ist es allerdings erforderlich, dass das Rohr eine entsprechende Länge aufweist, um einen entsprechenden thermischen Widerstand zu haben, da sonst kein genügender Wärme-Transfer erfolgt.

Bei einer gegenwärtig beanspruchten Ausführungsform umfasst die Wärme-Transfer-Anordnung einen Wärme-Transfer-Körper mit einer Wärmeübergangs-Fläche, die zwei- oder dreidimensional sein kann, und die auf eine entsprechende Fläche der Wärme-Senke gepresst wird, sowie eine Vorspann-Einrichtung, die die Wärmeübergangs-Fläche mit variabler, von der zu transferierenden Wärmemenge bestimmter Kraft auf die Fläche der Wärme-Senke hin vorspannt, wobei sich bei einer Erhöhung des Anpressdruckes der Wärmeübergang zwischen der Wärmeübergangs-Fläche und der Wärme-Senke steigert. Die Vorspann-Einrichtung ist so ausgebildet, dass die durch sie ausgeübte Vorspannkraft zunimmt, wenn die Temperatur der Laser-Diode ansteigt. Der Wärme-Transfer-Körper seinerseits erhält die zu transferierende Wärmemenge von der Laser-Diode auf einem Wärmeleitpfad durch Wärmeübergang sowie durch Wärmeleitung.

In dieser Ausführungsform umfasst die Vorspann-Einrichtung eine Balg-Einrichtung, welche mit einem flüssigen und/oder gasförmigen Stoff bzw. einem Stoffgemisch gefüllt ist, dessen Druck sich unter den Temperaturen, die bei der Verwendung der Balg-Einrichtung herrschen, merklich ändert. Die Balg-Einrichtung ist so ausgebildet und angeordnet, dass daraus eine in der erforderlichen Weise temperaturabhängige Vorspannkraft resultiert; bei einer Erhöhung der Temperatur der Laser-Diode erhöhen sich die Temperatur und damit das Volumen des im Balg befindlichen Stoffes, woraus eine höhere Vorspannkraft resultiert. Wie bei der Variante mit den Rohren mit einem Arbeits-Fluid mit variabler Wärmeleitfähigkeit benutzt man also die physikalische Korrelation von Temperatur und Fluiddruck, hier jedoch nicht zur Variation der Wärmeleitfähigkeit des Fluides selbst, sondern zur Variation des Wärmeüberganges der von der mit Hilfe des Fluides erzeugten Vorspannkraft abhängig ist.

Weitere Eigenschaften und Vorteile der Erfindung werden im folgenden anhand von mehreren Ausführungsbeispielen und mit Bezug auf die Zeichnung beschrieben. Es zeigen:
- **Fig. 1**: eine erstes nicht beanspruchtes Ausführungsbeispiel einer Wärme-Transfer-Anordnung, die als U-förmig gebogenes, ein Arbeits-Fluid enthaltendes Rohr ausgebildet ist, in vereinfachter Darstellung;
- **Fig. 2**: eine zweites nicht beanspruchtes Ausführungsbeispiel einer Wärme-Transfer-Anordnung, die als L-förmig gebogenes, ein Arbeits-Fluid enthaltendes Rohr ausgebildet ist, in vereinfachter Darstellung;
- **Fig. 3**: ein beanspruchtes Ausführungsbeispiel einer Wärme-Transfer-Anordnung, die eine auf eine Fläche der Wärme-Senke vorspannbare Wärmeübergangs-Fläche und eine die erforderliche Vorspannkraft erzeugende Vorspann-Einrichtung umfasst, in vereinfachter Darstellung;
- **Fig. 4**: das in Fig. 3 dargestellte Ausführungsbeispiel mit einer ersten Variante der Vorspann-Einrichtung, in schematischer Darstellung;
- **Fig. 5**: das in Fig. 3 dargestellte Ausführungsbeispiel mit einer zweiten Variante der Vorspann-Einrichtung, in schematischer Darstellung;
- **Fig. 6**: ein erstes Ausführungsbeispiel einer Einrichtung mit mehreren parallelen Wärme-Transfer-Anordnungen gemäss Fig. 4; und
- **Fig. 7**: ein zweites Ausführungsbeispiel einer Einrichtung mit mehreren parallelen Wärme-Transfer-Anordnungen gemäss Fig. 4.

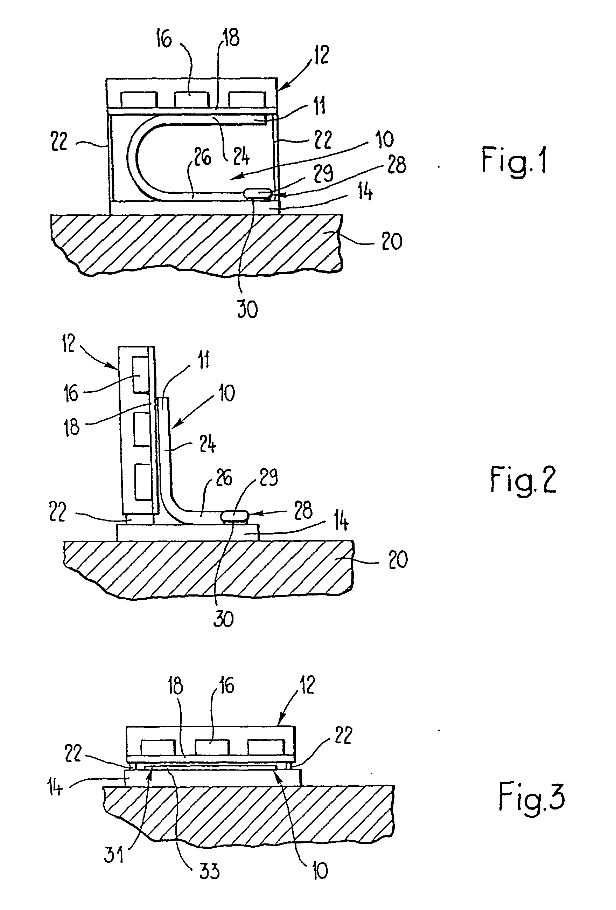

**Fig. 1** zeigt ein Wärme-Transfer-Anordnung **10** mit einem in Form eines U-förmig gebogenen, mit einem Arbeits-Fluid **11** gefüllten Rohr, welches zwischen einer Laser-Diode **12** und einer Wärme-Senke **14** angeordnet ist. Die Laser-Diode **12** umfasst mehrere Laser-Dioden-Komponenten **16** sowie eine Laser-Dioden-Grundplatte **18**. Die Wärme-Senke **14** ist plattenförmig ausgebildet und an einer Struktur **20** eines im weiteren nicht dargestellten Satelliten angeordnet. Zwischen der Laser-Dioden-Grundplatte **18** und der Wärme-Senke **14** befindet sich eine Wärme-Isolations-Struktur **22.**

Der an der Laser-Dioden-Grundplatte **18** angeordnete Bereich der Wärme-Transfer-Anordnung **10** bildet eine Verdampferzone **24,** in welcher Wärme von der Laser-Dioden-Grundplatte **18** via die Wandung des Rohres an das Arbeits-Fluid **11** transferiert wird, wodurch das letztere verdampft. Der an der Wärme-Senke **14** angeordnete Bereich der Wärme-Transfer-Anordnung **10** bildet eine Kondensationszone **26**, in welcher Wärme vom Arbeits-Fluid **11** via die Wandung des Rohres an die Wärme-Senke **14** transferiert wird, wobei das Arbeits-Fluid **11** kondensiert.

Am Ende der Kondensationszone **26** setzt sich das Rohr in einem Gas-Reservoir **28** fort, in welchem sich ein Inertgas **29** befindet. Das Gas-Reservoir **28** ist mittels einer nicht dargestellten Heizvorrichtung beheizbar und durch eine Isolation **30** in einem gewissen Masse gegen die Wärme-Senke **14** isoliert. Das Inertgas **29** dehnt sich bei steigender Temperatur in das Rohr aus; je mehr Volumen das Inertgas **29** einnimmt, desto kleiner wird die Kondensationszone **26,** und desto geringer wird der Wärmetransfer. Die Beheizung des Gas-Reservoirs **28** muss also dann erfolgen, wenn von der Laser-Diode **12** verhältnismässig wenig Wärme zur Wärme-Senke **14** transferiert werden muss.

**Fig. 2** zeigt eine in Aufbau und Wirkungsweise im Prinzip gleiche Anordnung, mit einer Laser-Diode **12,** umfassend eine Wärme-Transfer-Anordnung **10** mit einem Gas-Reservoir **28**, mehrere an einer Grundplatte **18** angeordnete Laser-Dioden-Komponenten **16** und eine Wärme-Senke **14**. Die Wärme-Transfer-Anordnung **10** enthält das Arbeits-Fluid **11** und das Gas-Reservoir **28** enthält das Inertgas **29**, welches sich in das die Wärme-Transfer-Anordnung **10** bildende Rohr ausdehnen kann. Im Unterschied zur Wärme-Transfer-Anordnung der **Fig. 1** ist diese Wärme-Transfer-Anordnung **10** nicht als U-förmiges sondern als L-förmiges Rohr ausgebildet.

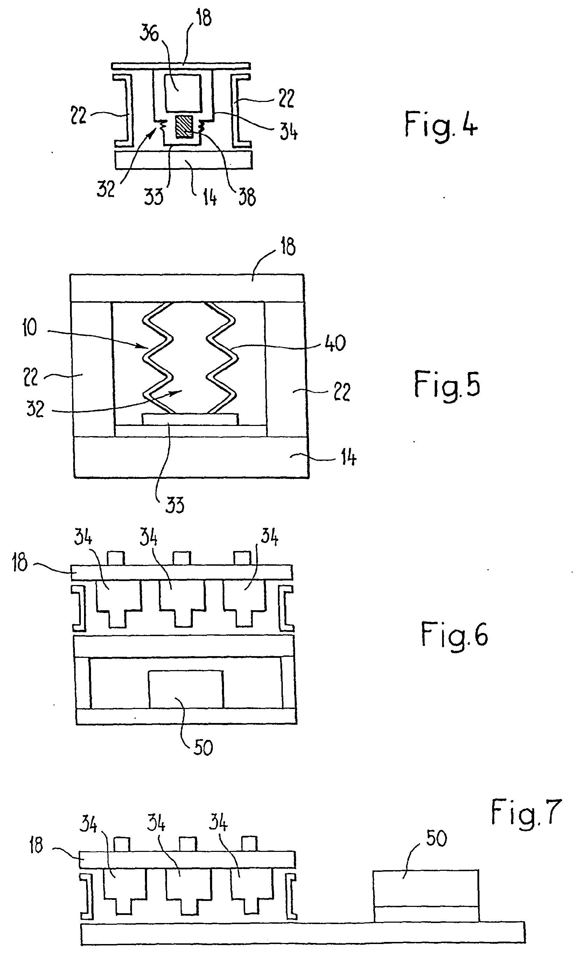

**Fig. 3** zeigt eine Wärme-Transfer-Anordnung **10** mit einem Wärme-Transfer-Körper **31**, welcher eine Wärmeübergangs-Fläche **33** besitzt, die mittels einer in den **Fig. 4** bzw. **5** näher dargestellten Vorspann-Einrichtung **32** mit variabler Kraft auf die Wärme-Senke **14** bzw. eine geeignete Fläche derselben vorspannbar ist; bei höherer Vorspannkraft bzw. grösserem Druck vergrössert sich der ist der Wärmeübergang von der Wärmeübergangs-Platte **33** an die Wärme-Senke **14** und damit der Wärme-Transfer von der Laser-Diode **12** an die Wärme-Senke **14**. Die Laser-Diode **12** weist auch hier mehrere Laser-Dioden-Komponenten **16** und eine Grundplatte **18** auf, und die Wärme-Senke **14** ist an der Struktur **20** des im weiteren nicht dargestellten Satelliten angeordnet. Die Grundplatte **18** und die Wärme-Senke **14** sind auch hier durch eine Wärme-Isolations-Struktur **22** verbunden.

In **Fig. 4** ist eine Variante der Vorspann-Einrichtung **32** genauer dargestellt. Im Raum zwischen der Grundplatte **18** der nicht weiter dargestellten Laser-Diode und der Wärme-Senke **14,** der durch die Wärme-Isolations-Struktur **22** begrenzt ist, befindet sich eine Balgeinrichtung **34,** in welcher ein Stoff **36,** beispielsweise Paraffin, angeordnet ist, dessen Volumen sich in Abhängigkeit von der Temperatur der Laser-Diode **12** merklich ändert. Zwischen dem Stoff **36** und der Wärmeübergangs-Platte **33** ist eine Stempel-Einrichtung **38** angeordnet, mit welchem die Wärmeübergangs-Platte **33** beaufschlagt wird. Bei höherer Temperatur der Laser-Diode bzw. ihrer Grundplatte **18** vergrössern sich das Volumen des Stoffes **36** und damit die Vorspannkraft, die die Stempel-Einrichtung **38** auf die Wärmeübergangs-Platte **33** ausübt, so dass der Wärme-Transfer zunimmt. Umgekehrt nehmen bei einem Sinken der Temperatur der Grundplatte **18** der Wärme-Diode das Volumen des Stoffes **36** und die Vorspannkraft der Stempel-Einrichtung **38** ab, so dass der Wärme-Transfer reduziert wird.

**Fig. 5** zeigt eine Anordnung entsprechend **Fig. 4,** mit der Grundplatte **18** der Laser-Diode und der Wärme-Senke **14**, welche über die Wärme-Isolations-Struktur **22** verbunden sind, sowie mit der Wärme-Transfer-Anordnung **10,** welche die Wärmeübergangs-Platte **33** und die Vorspann-Vorrichtung **32** umfasst. Die Vorspann-Vorrichtung **32** umfasst hier eine Feder **40** aus einem Memory-Metall.

In **Fig. 6** ist eine Einrichtung dargestellt, in welcher der Wärme-Transfer von der Grundplatte **18** der Laser-Diode durch drei parallele Wärme-Transfer-Anordnungen **34** geschieht, welche im wesentlichen gemäss **Fig. 4** aufgebaut sind. Die Elektronik **50** ist unterhalb der Wärme-Transfer-Anordnungen **34** angeordnet. Auf diese Weise ist eine in seitlicher Richtung platzsparende Anordnung möglich.

**Fig. 7** zeigt eine im wesentlichen gleiche Einrichtung wie **Fig. 6**, jedoch ist die Elektronik **50** neben den Wärme-Transfer-Anordnungen **34** angeordnet. Bei einer solchen Anordnung wird zwar seitlich mehr Raum benötigt, dagegen ist die Bauhöhe geringer als bei der Einrichtung gemäss **Fig. 6**.

## Patentansprüche

1. Vorrichtung zur Begrenzung der Temperatur einer Lichtwellen emittierenden Laser-Diode (**12**) und zur Verwendung in einem Weltraum-Satelliten, wobei die Vorrichtung eine Wärme-Transfer-Anordnung (**10**) umfasst, durch welche Wärme von der Laser-Diode (**12**) zu einer Wärme-Senke (**14**) transferiert wird, wobei die Wärme-Transfer-Anordnung (**10**) eine variable Wärme-Transfer-Kapazität hat, wobei die genannte variable Wärme-Transfer-Kapazität direkt mit der Temperatur der Laser-Diode (**12**) korreliert ist,
**dadurch gekennzeichnet,**
**dass** die Wärme-Transfer-Anordnung (**10**) einen Wärme-Transfer-Körper (**31**) mit einer Wärmeübergangs-Fläche (**33**) und einer Vorspann-Einrichtung (**32**) aufweist, die mit variabler Kraft auf die Wärme-Senke (**14**) oder eine Fläche derselben vorspannbar ist, und die Vorspann-Einrichtung (**32**) eine Balgeinrichtung (**34**) aufweist, die eine den Wärme-Transfer-Körper (**31**) beaufschlagenden Stempel-Einrichtung (**38**) und einen auf die Stempel-Einrichtung (**38**) wirkenden Stoff (**36**) enthält, dessen Volumen sich temperaturabhängig im Bereich der Temperaturen von Laser-Diode (**12**) und Wärme-Senke (**14**) verändert, wobei bei höherer Vorspannkraft sich die Wärme-Transfer-Kapazität von der Wärmeübergangs-Fläche (**33**) an die Wärme-Senke (**14**) vergrössert und damit mehr Wärme von der Laser-Diode (**12**) an die Wärme-Senke (**14**) transferierbar ist.

2. Vorrichtung nach Patentanspruch 1,
**dadurch gekennzeichnet,**
**dass** die Wärme-Transfer-Anordnung (**10**) so ausgebildet ist, dass sie zusammen mit weiteren konstruktiven Elementen zwischen der Laser-Diode (**16, 18**) und der Wärme-Senke (**14**) angeordnet ist.

3. Vorrichtung nach mindestens einem der obigen Patentansprüche,
**dadurch gekennzeichnet,**
**dass** sie mindestens eine weitere Wärme-Transfer-Anordnung (**10**) aufweist.

4. Vorrichtung nach Patentanspruch **3**,
**dadurch gekennzeichnet,**
**dass** die Wärme-Transfer-Anordnungen (**10**) parallel angeordnet sind.

## Claims

1. Device for limiting the temperature of a lightwave-emitting laser diode (**12**) and for use in space satellites, whereby the device comprises a heat transfer arrangement (**10**) by which heat is transferred from the laser diode (**12**) to a heat sink (**14**), whereby the heat transfer arrangement (**10**) possesses a variable heat transfer capacity, whereby the variable heat transfer capacity is directly correlated with the temperature of the laser diode (**12**),
**characterized in that**
the heat transfer arrangement (**10**) displays a heat transfer body (**31**) with a heat transit surface (**33**) and a preloading device (**32**) which can be preloaded with a varying degree of force on the heat sink (**14**) or one surface of the same, and the preloading device (**32**) displays a bellows device (**34**) containing a plunger device (**38**) and a substance (**36**) which acts on the plunger device (**38**) and the volume of which alters as a function of temperature in the range of temperatures of laser diode (**12**) and heat sink (**14**), whereby at a higher preloading force the heat transfer capacity of the heat transit surface (**33**) to the heat sink (**14**) increases, thus enabling more heat to be transferred from the laser diode (**12**) to the heat sink (**14**).

2. Device according to Claim 1,
**characterized in that**
the heat transfer arrangement (**10**) is so constructed that it is arranged together with other constructional components between the laser diode (**16, 18**) and the heat sink (**14**).

3. Device according to at least one of the preceding Claims,
**characterized in that**
it displays at least one additional heat transfer arrangement (**10**).

4. Device according to Claim **3**,
**characterized in that**
the heat transfer assemblies (**10**) are arranged in parallel.

## Revendications

1. Dispositif destiné à limiter la température d'une diode laser (12) émettant des ondes lumineuses et destiné à une utilisation dans un satellite spatial, dans lequel le dispositif comprend un dispositif de transfert de chaleur (10) par le biais duquel de la chaleur est transférée de la diode laser (12) vers un puits de chaleur (14), dans lequel le dispositif de transfert de chaleur (10) a une capacité de transfert de chaleur variable, dans lequel la capacité de transfert de chaleur variable nommée est directement corrélée à la température de la diode laser (12),
**caractérisé en ce que**
le dispositif de transfert de chaleur (10) présente un corps de transfert de chaleur (31) qui a une surface de transmission de chaleur (33) et un dispositif de précontrainte (32) qui peut être précontraint selon une force variable sur le puits de chaleur (14) ou une surface de celui-ci, et
le dispositif de précontrainte (32) présente un dispositif à soufflet (34) qui contient un dispositif à piston (38) chargeant le corps de transfert de chaleur (31) et une substance (36) agissant sur le dispositif à piston (38), dont le volume se modifie en fonction de la température dans la gamme des températures de la diode laser (12) et du puits de chaleur (14), suite à quoi, avec une force de précontrainte plus élevée, la capacité de transfert de chaleur de la surface de transmission de chaleur (33) vers le puits de chaleur (14) est augmentée et, par conséquent, plus de chaleur peut être transférée depuis la diode laser (12) vers le puits de chaleur (14).

2. Dispositif selon la revendication 1, **caractérisé en ce que** le dispositif de transfert de chaleur (10) est exécuté de façon telle qu'il est disposé avec d'autres éléments de construction entre la diode laser (16, 18) et le puits de chaleur (14).

3. Dispositif selon au moins l'une des revendications précédentes, **caractérisé en ce qu'**il présente au moins un autre dispositif de transfert de chaleur (10).

4. Dispositif selon la revendication 3, **caractérisé en ce que**
les dispositifs de transfert de chaleur (10) sont disposés parallèlement.
